(19) Europäisches Patentamt

European Patent Office

Office européen des brevets

(11) Publication number: **0 032 847**

**B1**

(12) **EUROPEAN PATENT SPECIFICATION**

(45) Date of publication of patent specification: **08.05.85**

(51) Int. Cl.⁴: **H 01 L 31/02, H 01 L 27/14**

(21) Application number: **81300269.8**

(22) Date of filing: **21.01.81**

(54) Photoelectric conversion element and an image pick-up device.

(30) Priority: **21.01.80 JP 4622/80**

(43) Date of publication of application:
**29.07.81 Bulletin 81/30**

(45) Publication of the grant of the patent:
**08.05.85 Bulletin 85/19**

(84) Designated Contracting States:
**DE FR GB NL**

(56) References cited:
**EP-A-0 025 872**
**EP-A-0 031 663**
**JP-A-51 095 720**
**US-A-4 167 015**

**THE CONFERENCE OF THE TWELFTH IEEE
PHOTOVOLTAIC SPECIALISTS CONFERENCE
1976, 15th-18th November 1976, pages 893-
895, Baton Rouge, Louisiana, U.S.A., D.E.
CARLSON et al.: "Solar cells using Schottky
barriers on amorphous silicon"**

(73) Proprietor: **Hitachi, Ltd.**
**5-1, Marunouchi 1-chome**
**Chiyoda-ku Tokyo 100 (JP)**

(72) Inventor: **Shimomoto, Yasuharu**
**2196-92 Hirai Hinodemachi**
**Nishitama-gun Tokyo (JP)**
Inventor: **Tanaka, Yasuo**
**1-217-AI Higashi-koigakubo Kokubunji-shi**
**Tokyo (JP)**
Inventor: **Takasaki, Yukio**
**1-47-1-D401 Akatsuki-cho Hachioji-shi**
**Tokyo (JP)**
Inventor: **Ishioka, Sachio**
**1-49-2 Zoushigaya Toshima-ku**
**Tokyo (JP)**
Inventor: **Tsukada, Toshihisa**
**4-kou704-17-B405, Sekimachi Nerima-ku**
**Tokyo (JP)**
Inventor: **Baji, Toru**
**3-1-3 Higashi-koigakubo Kokubunji-shi**
**Tokyo (JP)**

(74) Representative: **Paget, Hugh Charles Edward
et al
MEWBURN ELLIS & CO. 2/3 Cursitor Street
London EC4A 1BQ (GB)**

Courier Press, Leamington Spa, England.

# 0 032 847

**Description**

This invention relates to a photoelectric conversion element and more particularly to the construction of a light-receiving surface that can be used for example in a photoconductive type image pick-up tube target or a solid state imager.

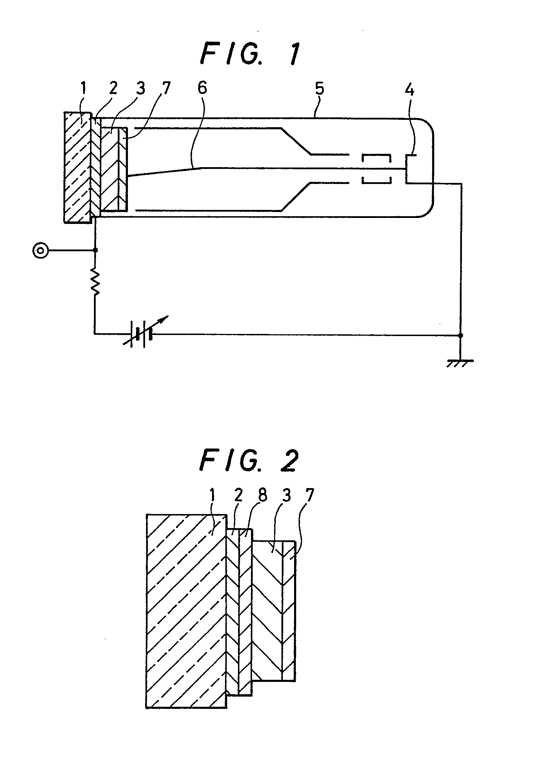

A typical example of a photoelectric conversion element that can be used in a storage mode occurs in a photoconductive type image pick-up tube, such as that shown in Figure 1 of the accompanying drawings. This tube consists of a light-transmitting substrate 1, generally called a "face plate", a transparent conductive film 2, a photoconductive layer 3, an electron gun 4 and a jacket 5. An optical image formed on the surface of the photoconductive layer 3 through the face plate 1 is subjected to photoelectric conversion, is stored in the form of charge patterns on the surface of the photoconductive layer and is read sequentially by a scanning electron beam 6. Commonly, a beam impingement layer 7 is formed on the surface of the photoconductive layer 3, in order to prevent the inversion and the injection of electrons from the scanning electron beam.

One of the significant characteristics required of the photoconductive layer 3 is that the charge patterns do not decay by diffusion during the time interval in which specific picture elements are scanned by the scanning electron beam 6 (i.e. during the storage time).

A prior art reference that proposes the use of an amorphous material consisting principally of silicon and containing hydrogen for the photoconductive layer is "Appln. Phys. Lett.", 35(4), 15 Aug., 1979, p 349—351.

A solid state imager using a photoconductor is disclosed, for example in "International Electron Devices Meeting", December 1979, p. 134—136. The photoconductor used in this disclosure is a Se-Ge-As chalcogenide glass.

In the photoelectric conversion element using hydrogenated amorphous silicon for the photoconductive layer, a problem is found in that adhesion between the silicon and the substrate is not sufficient, which causes numerous spots to occur on the surface of the photoelectric conversion element.

Accordingly, the present invention is directed to the solution of the above mentioned problem. To this end, in the present invention the photoconductive layer is formed of a photoconductive amorphous material consisting principally of silicon but which also contains hydrogen on a first electrode having a metallic surface film containing at least one of Ta, Cr, W, Nd, Mo, V and Ti. This arrangement provides sufficient bonding strength between the amorphous material and the substrate.

The metallic film may be either a film of a single substance or a composite film. It may alternatively be a multi-layered film. An alloy of two or more of the above mentioned elements may be used.

It is also possible to use this metallic film as a metallic electrode. In this case, the film may itself form the ordinary electrode. The film thickness is generally in the range from 2000 Å to 1 µm. If this film is simultaneously used as a transparent electrode in a multi-layered construction, it is of course necessary that the film used for adhesive purposes is also substantially transparent or semi-transparent. Generally a thickness of from 5 Å to 100 Å is preferred. If there is an Al electrode or the like below the film, the film for adhesion may be disposed on the Al electrode. If the metallic film is disposed where electrical conduction is not required, the film thickness is preferably as thin as 20 Å to 200 Å and more preferably is from 50 Å to 100 Å. Alternatively the metallic film can be suitably divided into segments so that the film as a whole has substantially no conductivity.

The metallic film may be formed by an ordinary sputtering method, for which the conditions are generally as follows. It may be either RF sputtering or DC sputtering. The atmosphere used comprises a dilute gas, such as argon at from $5\times10^{-4}$ to $1\times10^{-2}$ Torr while an input power of about 200 to about 800 W may be used.

The metallic film may alternatively be formed by the ordinary vacuum evaporation method.

The photoconductive film in accordance with the present invention consists of a single layer or a laminate layer. Generally, it is preferred to use an amorphous material containing silicon and hydrogen in such amounts that the single layer or at least one layer of the laminate layer, of photoconductive substance contains at least 50 atom % silicon and 5 to 50 atom % hydrogen, and at the same time has a resistivity of at least $10^{10}$ Ohm . cm. It is also possible to use a material in which from 0.1% to 50% of the silicon atoms are substituted by germanium atoms. Generally, the thickness of the photoconductive film is in the range of from 100 nm to 20 µm. The amorphous material can be produced for example by an ordinary reactive sputtering method or with an ordinary decomposition method by means of a glow discharge.

Embodiments of the present invention will now be described in detail by way of example with reference to the accompanying drawings in which:—

Figure 1 shows the construction of an image pick up tube;

Figure 2 shows, in section, the construction of a photoelectric convertor in accordance with the present invention;

Figure 3 is a diagram showing the current voltage characteristics of the target;

Figure 4 shows the principle of the solid state imager;

Figures 5 to 7 are sectional views showing the principal portions of a solid state imager of the present invention during its production;

2

Figure 8 is a plan view of an embodiment of a solid state imager element according to the present invention; and

Figures 9 and 10 are sectional views showing the principal portions of another photoelectric conversion element embodying the present invention.

Example 1

As shown in Figure 2, a transparent electrode 2 consisting of $SnO_2$ was formed on a glass substrate 1 and was fitted to a substrate holder electrode inside a high frequency sputtering device. A Ta target was mounted onto a target electrode. Next, after the inside of the sputtering chamber had been exhausted to a degree of vacuum of $5 \times 10^{-6}$ or below, Ar gas was introduced into the chamber so as to attain a gas pressure of $1.0 \times 10^{-2}$ Torr.

At this gas pressure, high frequency discharge of 13.56 MHz with an output of 1 W/cm² was effected between the electrodes, thereby forming a Ta film 8 on the transparent electrode 2 to a thickness of about 10 Å.

Next, a 99.999% silicon sintered body was mounted on the target electrode and reactive sputtering of the amorphous silicon film 3 was effected onto the Ta film 8 in an atmosphere consisting of $3 \times 10^{-3}$ Torr of Ar and $2 \times 10^{-3}$ Torr of $H_2$. The substrate was held at 200°C. The amorphous silicon film thus produced had about 10 atom % hydrogen and a resistivity of $10^{14}$ Ohm . cm.

In order to improve the impingement characteristics of the electron beam an $Sb_2S_3$ film 7 was finally vacuum deposited to a thickness of about 1,000 Å under Ar gas.

In this manner, the target of the image pick-up tube was completed. Peeling of the amorphous material from the film could be completely eliminated. If the photoconductive film suffers from peeling, numerous spots occur on the picture surface of the image pick-up tube using such a target. This problem could be entirely eliminated using this method. Furthermore increase in the dark current due to the film peeling could be prevented or reduced about one hundred fold.

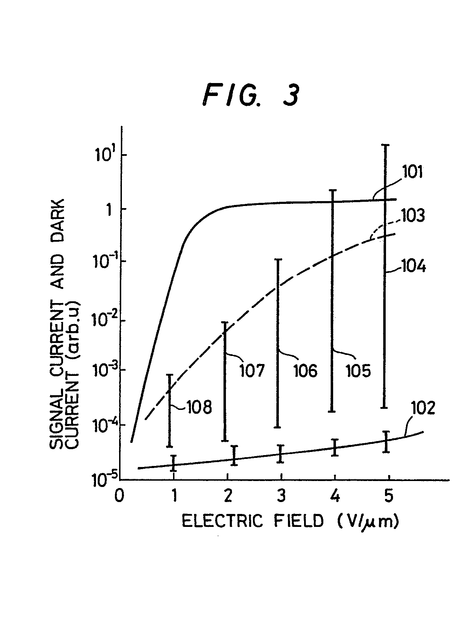

Figure 3 shows the current-voltage characteristics of an amorphous silicon vidicon target. The photocurrent was measured using 10-lux illumination (blue light) on the face plate. Curves 101 and 102 represent the signal current and dark current respectively as measured for the target embodying the present invention (the units are arbitrary). The curve 103 represents the signal current when the present invention was not used and lines 104 to 108 represent the dark current in each electric field when the present invention was not used. The signal levels in these cases are inferior to those obtained with the present invention, and the difference is further observed very clearly with respect to the dark current characteristics. If film peeling occurs, the target exhibits an extremely large dark current as shown in Figure 3 so that it can not be used in practice.

In contrast, excellent current-voltage characteristics could be obtained using this embodiment of the present invention.

Example 2

A plurality of transparent electrodes consisting of $SnO_2$—$In_2O_3$ were formed on glass substrates and the metallic films shown in Table 1 were formed thereon by sputter evaporation as in Example 1. Then, a silicon layer containing 15 atom % of hydrogen was formed to a thickness of 2 μm by the reactive sputtering method. Finally, an $Sb_2S_3$ film was vacuum evaporated under Ar gas, thereby providing a target for an image pick-up tube. Each target exhibited excellent characteristics in the same way as in the target of Example 1.

TABLE 1

| Metal | Film thickness (Å) |
|---|---|
| Cr | 10 |
| W | 10 |
| Nd | 10 |
| Mo | 10 |
| V | 10 |
| Ti | 10 |
| Composite film of Cr and W | 10 |
| Composite film of Ta and Mo | 10 |

Example 3

This embodiment relates to a solid state imager using a photoconductive layer.

This solid state imager has a construction in which a plurality of solid elements each having a photoelectric conversion function and a signal storage function are so arranged that each solid element corresponds to one picture element so as to form an image surface, and the resulting image surfaces are sequentially scanned so as to convert external picture information into electric signals. An example of a solid state imager in which the photoconductive layer forming the image surface covers a semiconductor substrate having formed thereon a switch, a scanning circuit and the like, is disclosed in Japanese Laid Open Patent No. 10715/1976.

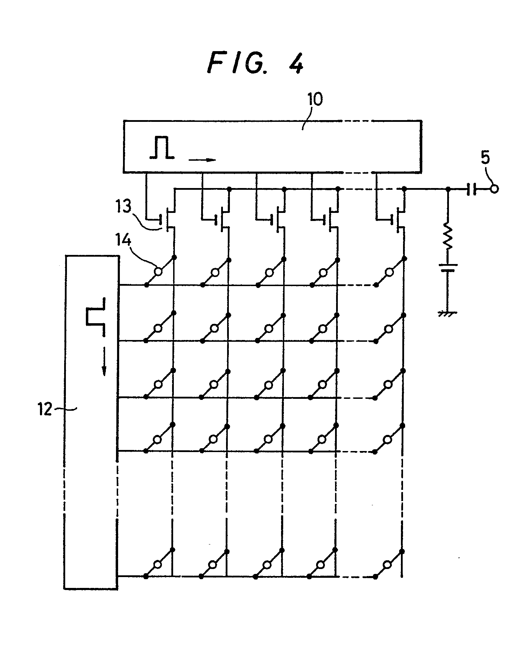

Figure 4 shows the principle of the solid state imager. The picture elements 14 are arranged in a matrix and are read out one by one by an XY address system. Selection of the picture elements is made by means of a horizontal scanning signal generator 11 and a vertical scanning signal generator 12. Switch portions 13 are connected to the picture elements and to output terminals 5.

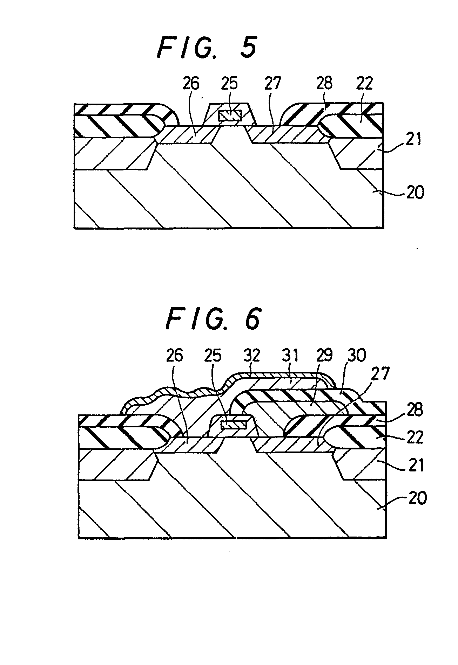

Figures 5 to 7 are sectional views of the picture element portions showing a method of production of a solid state imager embodying the present invention. The switching circuit formed on the semiconductor substrate, the scanning circuit portions and the like were produced in accordance with the ordinary fabrication methods used for semiconductor devices. An $SiO_2$ film as thin as about 800 Å was formed on a P-type silicon substrate 20 and an approximately 1400 Å-thick $Si_3N_4$ film was then formed at a predetermined position on this $SiO_2$ film.

The $SiO_2$ film was formed by the ordinary CVD process while the $Si_2N_3$ film was formed by the CVD process in the presence of $Si_3N_4$, $NH_4$ and $N_2$. A p-type diffusion region 21 was formed from the upper portion of the silicon substrate by ion implantation. This diffusion region was formed in order to improve separation of the picture elements. Next, silicon was locally oxidized in an atmosphere consisting of $H_2$ and $O_2$ in the ratio $H_2:O_2=1:8$, thereby forming an $SiO_2$ layer 22. This process is a local oxidation process for silicon that is generally referred to as an "LOCOS". The above mentioned $Si_3N_4$ and $SiO_2$ film were then removed and a gate insulation film of an MOS transistor was formed by the $SiO_2$ film. Next, a gate portion 25 of poly-silicon and diffusion regions 26, 27 were formed and an $SiO_2$ film 28 was formed on them. In this film were bored electrode extension portions of source 26 and drain 27 by etching (Fig. 5). As a drain electrode 29, Al was vacuum evaporated to a thickness of 8000 Å. A $SiO_2$ film 30 was then formed to a thickness of 7500 Å, followed by vacuum deposition of 1 µm thick Al as the source electrode 31. A Ta layer 32 was then sputter evaporated to a thickness of 100 Å. Figure 6 is a sectional view showing this state. Incidentally, the electrode 31 was formed so as to cover the regions 26, 27 and the gate portion. This arrangement was employed because if the light enters the signal processing region between the diffusion layers 21 separating the elements, it causes undesirable blooming.

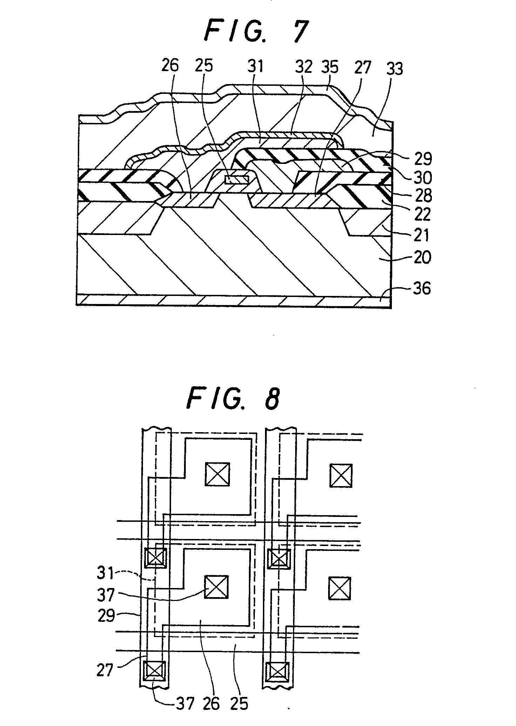

Circuits such as shift registers and the like were disposed around the light receiving region, and the scanning circuit portion was thus completed. The light receiving portion was formed at the upper portion of this scanning circuit portion. Figure 8 is a plan view of the Si substrate portion, showing an electrode contact hole 37. In this drawing, the same reference numerals as used in the sectional view represent the same constituents.

Next, and as shown in Figure 7, an amorphous silicon layer 33 containing 15 atom % of hydrogen was formed to a thickness of 2 µm by the reactive sputtering process.

A transparent electrode 35 was formed on this layer 33, thereby completing the solid state imager. As the transparent electrode, it is possible to use a ultra-thin film of gold or the like or a transparent electro-conductive film containing indium oxide or tin oxide, or a ribbon like metallic film.

Finally, a conductive film 36 forming an ohmic contact was disposed on the other surface of the semiconductor substrate 20. Generally, this conductive film 36 is grounded through a terminal.

Cr-Au was vacuum evaporated onto a part of the transparent electrode using a mask, and wire-bonding was effected at this portion so as to form a biasing electrode.

In this manner, the solid state imager using the amorphous silicon as the photoconductive film was completed. As the Ta layer 32 was disposed at the upper portion of the substrate on which the amorphous silicon film 33 was to be formed, peeling of the amorphous silicon film could be completely eliminated. Thus, it is possible to eliminate the white spots due to the peeling of the picture surface film of the solid state image pick up element.

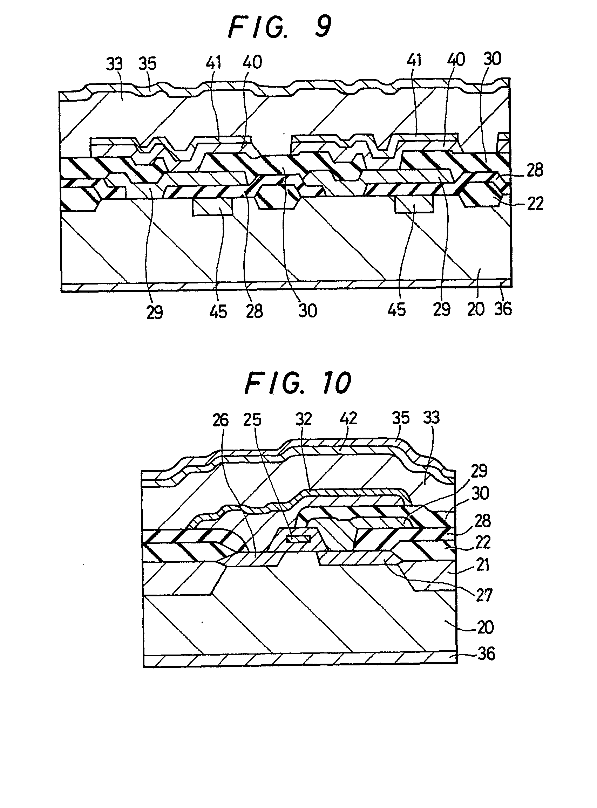

The embodiment of Figures 5 to 7 is one in which the metal layer serving as the adhesive layer is laminated on the metal layer forming the electrode. In the solid state imager, the electrode 31 *per se* may consist of a metal which is to serve as the adhesive layer. The construction of the electrode portion is of course not specifically restricted to that used in this embodiment. Figure 9 shows an example in which the present invention was applied to an electrode having a two-layered construction. Its fundamental construction is the same as in the foregoing examples. It has an impurity layer 45 in the silicon substrate 20 and an insulation film 22 for separating the picture elements consisting of $SiO_2$ or the like. An insulation film 28 consisting of $SiO_2$ or P-containing $SiO_2$. A lower electrode 29 consisting of Al was disposed on the insulation film 28 and an upper electrode 40 was further formed thereon via the insulation film 30. The metallic film 41 of the present invention was formed of Ta on the upper electrode 40. In the same way as in the foregoing examples, the photoconductive film 33 and the transparent electrode 35 were sequentially formed, thereby providing the solid state image pick up element.

4

Although the scanning circuit in this example consisted of MOS field effect transistors, the present invention is not restricted to this construction. It is of course possible to use a CCD (Charge Coupled Device) transfer region as the scanning circuit, for example. It is further possible to use MOS transistors or other circuit systems.

When any of the metals listed in the aforementioned Table 1 was used as the adhesive layer the same effect could be obtained.

The present invention can be adapted to photoelectric conversion devices of various modified constructions using the above mentioned amorphous material consisting of silicon as the principal component and containing hydrogen, and also using a rectification contact type construction.

The present photoelectric conversion device can be further improved by a construction of the light-receiving surface which can sufficiently restrict the dark current even when a strong electric field is applied to the interface of junction.

Thus, in the present invention, a further film layer consisting principally of at least one of the oxides, nitrides and halides selected from the group listed below may be interposed between the photoconductive layer consisting of H-containing amorphous material and a signal electrode. Such film layers with the corresponding effect have already been disclosed in EP—A—0 031 663.

(1) Oxides

Oxides of at least one of the elements Si, Ti, Al, Mg, Ba, Ta, W, Bi, V, Ge, Ni, Th, Mo, Fe, La, Be, Sc and Co.

Particular examples includes $SiO_2$, $TiO_2$, $Al_2O_3$, $MgO$, $BaO$, $Ta_2O_5$, $WO_3$, $Bi_2O_3$, $V_2O_5$, $GeO$, $NiO$, $ThO_2$, $Fe_2O_3$, $La_2O_3$, $MoO_3$, $BeO$, $Sc_2O_3$, $Co_2O_3$ and their eutectic mixtures.

(2) Nitrides

Nitrides of at least one of the elements Ga, Si, Mg, Ta, Hf, Zr, Nb and B.

Particular examples include $GaN$, $Si_3N_4$, $Si_2N_3$, $MgN_2$, $TaN$, $HfN$, $ZrN$, $NbN$, $BN$ and their eutectic mixtures.

(3) Halides

Halides of at least one of the elements Na, Mg, Li, Ba, Ca and K.

Particular examples include $MgF_2$, $LiF$, $NaF$, $BaF_2$, $CaF_2$, $KF$ and their eutectic mixtures.

It is also possible to use a layer composed of a mixture or a laminate layer.

$SiO_2$, $BaO$, $TiO_2$, $Ta_2O_5$ or $Al_2O_3$ as the oxide, $Si_3N_4$ or $TaN$ as the nitride and $LiF$ or $MgF_2$ as the halide can exhibit extremely good characteristics, followed by $MgO$, $WO_3$, $V_2O_5$, $NiO$, $Fe_2O_3$, $MoO_3$ or $Co_2O_3$ as the oxide, $GaN$, $Si_2N_3$ or $MgN_2$ as the nitride and $BaF_2$, $NaF$ and $KF$ as the halide. Good characteristics can also be obtained from $Bi_2O_3$, $GeO$, $ThO_2$, $La_2O_3$, $BeO$ or $ScO_3$ as the oxide and $HfN$, $ZnN$, $NbN$ or $BN$ as the nitride.

The film thickness ranges from about 50 Å to about 5000 Å. Especially when the film thickness is below 1000 Å, there are no problems such as a decrease in the transmissivity of the incident light or reduction of the sensitivity of the photoelectric conversion device.

Generally, it is much preferable that the above mentioned oxide layer be formed by the sputtering vacuum deposition process using the same oxide as the material for vacuum deposition.

The sputtering vacuum deposition generally uses a high frequency discharge in Ar gas at $1 \times 10^{-1}$ Torr to $1 \times 10^{-3}$ Torr. If the oxide is likely to be reduced and to become blackened in this instance, it is advisable to blend up to about 5% by volume of oxygen with the Ar gas.

Though the temperature of the substrate during vacuum evaporation may be 25 to 400°C, it is preferably from 100 to 250°C in order to prepare a flat film.

It should be noted that the film layer consisting of the abovementioned oxide, nitride or halide is interposed between the photoconductive film and the signal electrode, such as disclosed in the above mentioned EP—A—0 031 663 but it is not always necessary for the film to be disposed adjacent to the signal electrode. In other words, a layer consisting of other materials may be interposed between the signal electrode and the film layer. However, it is necessary that the photoconductive film and the oxide be substantially adjacent to each other.

Figure 10 is a sectional view of a target of the invention of this type. Reference numeral 42 represents the above mentioned film layer for restricting the dark current. The other constituents are the same as those of Figure 7 and are represented by the same reference numerals. In different examples, the thin film layers shown in the following Tables 2 and 3 were employed as the layer 42, respectively, but peeling of the conductive film did not occur at all and the dark current could be restricted to a sufficiently low level even at a high target voltage. Details of the formation of the layers 42 by sputtering are given in Table 2, and the method of formation is indicated in Table 3.

# 0 032 847

## TABLE 2

| | Ar gas pressure (Torr) | High frequency output (W/cm$^2$) | Film thickness (Å) |
|---|---|---|---|
| TiO$_2$ | $4\times10^{-2}$ | 1 | 200 |
| BaO | $5\times10^{-3}$ | 1.5 | 240 |
| Ta$_2$O$_3$ | $5\times10^{-3}$ | 2 | 200 |
| Al$_2$O$_3$ | $3\times10^{-2}$ | 1.5 | 200 |
| MgO | $2.5\times10^{-3}$ | 0.5 | 220 |
| WO$_3$ | $5\times10^{-3}$ | 2 | 260 |
| V$_2$O$_5$ | $5\times10^{-3}$ | 2 | 250 |
| MoO$_3$ | $4\times10^{-3}$ | 1.7 | 200 |
| La$_2$O$_3$ | $2\times10^{-3}$ | 1 | 250 |
| SiO$_2$ | $1\times10^{-3}$ | 1 | 200 |

## TABLE 3

| | Fabrication method of blocking layer | Film thickness (Å) |
|---|---|---|
| Si$_3$N$_4$ | Decomposition by glow discharge | 220 |
| TaN | Reactive sputtering | 150 |
| LiF | Vacuum evaporation | 160 |
| MgF$_2$ | Electron beam evaporation | 200 |
| GaN | Reactive sputtering | 210 |
| MgN$_2$ | Reactive sputtering | 200 |
| CaF$_2$ | Electron beam evaporation | 220 |
| BaF | Electron beam evaporation | 240 |
| ZrN | Reactive sputtering | 280 |
| NaF | Vacuum evaporation | 200 |

## Claims

1. A photoelectric conversion element having an electrode (2, 31) and a photoconductive layer (3, 33) formed of an amorphous material comprising silicon and hydrogen adjacent said electrode (2, 31), the electrode (2, 31) and layer (3, 33) being on a substrate, characterized in that: said layer (3, 33) is adhered to said electrode (2, 31) by a metallic layer (8, 32) formed of at least one of the elements Ta, Cr, W, Nd, Mo, V and Ti.

2. An element according to claim 1 wherein said metallic layer (8, 32) forms at least part of said electrode (2, 31).

3. An element according to claim 1 or claim 2 wherein said electrode (2) and said metallic layer (8) are light transmitting.

4. An element according to any one of claims 1 to 3 wherein said substrate includes an electronic circuit for driving said photoelectric conversion element, said electrode (2, 31) is electrically connected to said electronic circuit and a light transmitting second electrode (7, 35) is disposed on said photoconductive layer (3, 33).

6

**0 032 847**

5. An element according to claim 4 wherein between said photoconductive layer (3, 33) and said second electrode (7, 35) a further layer (42) is provided comprising principally at least one of
oxides of at least one of the elements Si, Ti, Al, Mg, Ba, Ta, W, Bi, V, Ge, Ni, Th, Mo, Fe, La, Be, Sc and Co,
nitrides of at least one of the elements Ga, Si, Mg, Ta, Hf, Zr, Nb and B,
halides of at least one of the elements Na, Mg, Li, Ba, Ca and K.
6. An image pick-up device having a plurality of elements according to any one of the preceding claims.

**Patentansprüche**

1. Fotoelektrisches Umwandlungselement mit einer Elektrode (2, 31) und einer fotoleitfähigen Schicht (3, 33), die aus einem Silizium und Wasserstoff aufweisenden amorphen Material gebildet ist und neben der Elektrode (2, 31) liegt, wobei sich die Elektrode (2, 31) und Die Schicht (3, 33) auf einem Substrat befinden, dadurch gekennzeichnet, daß die genannte Schicht (3, 33) an der Elektrode (2, 31) durch eine metallische Schicht (8, 32) haftet, die aus zumindest einem der Elemente Ta, Cr, W, Nd, Mo, V und Ti gebildet ist.

2. Element nach Anspruch 1, wobei die metallische Schicht (8, 32) zumindest einen Teil der Elektrode (2, 31) bildet.

3. Element nach Anspruch 1 oder Anspruch 2, wobei die Elektrode (2) und die metallische Schicht (8) lichtdurchlässig sind.

4. Element nach einem der Ansprüche 1 bis 3, wobei das Substrat einen elektronischen Schaltkreis zur Ansteuerung des fotoelektrischen Umwandlungselementes aufweist, die Elektrode (2, 31) elektrisch mit diesem elektronischen Schaltkreis verbunden ist, und eine lichtdurchlässige zweite Elektrode (7, 35) auf der genannten fotoleitfähigen Schicht (3, 33) angeordnet ist.

5. Element nach Anspruch 4, wobei zwischen der fotoleitfähigen Schicht (3, 33) und der zweiten Elektrode (7, 35) eine weitere Schicht vorgesehen ist, die hauptsächlich zumindest eines
der Oxide von zumindest einem der Elemente Si, Ti, Al, Mg, Ba, Ta, W, Bi, V, Ge, Ni, Th, Mo, Fe, La, Be, Sc und Co,
der Nitride von zumindest einem der Elemente Ga, Si, Mg, Ta, Hf, Zr, Nb und B,
der Halogenide von zumindest einem der Elemente Na, Mg, Li, Ba, Ca und K aufweist.

6. Bild-Aufnahmevorrichtung mit einer Vielzahl von Elementen nach einem der vorhergehenden Ansprüche.

**Revendications**

1. Elément de conversion photoélectrique comportant une électrode (2, 31) et une couche photoconductrice (3, 33) constituée en un matériau amorphe contenant du silicium et de l'hydrogène et adjacente à ladite électrode (2, 31), cette électrode (2, 31) et la couche (3, 33) étant situées sur un substrat, caractérisé en ce que ladite couche (3, 33) adhère à ladite électrode (2, 31) grâce à une couche métallique (8, 32) constituée par au moins l'un des éléments Ta, Cr, W, Nd, Mo, V et Ti.

2. Elément selon la revendication 1, dans lequel ladite ouche métallique (8, 32) constitue au moins une partie de ladite électrode (2, 31).

3. Elément selon la revendication 1 ou 2, dans lequel ladite électrode (2) et ladite couche métallique (8) transmettent la lumière.

4. Elément selon l'une quelconque des revendications 1 à 3, dans lequel ledit substrat contient un circuit électronique servant à commander ledit élément de conversion photoélectrique, ladite électrode (2, 31) est raccordée électriquement audit circuit électronique et une seconde électrode (7, 35) transmettant la lumière est disposée sur ladite couche photoconductrice (3, 33).

5. Elément selon la revendication 4, dans lequel il est prévu entre ladite couche photoconductrice (3, 33) et ladite seconde électrode (7; 35), une couche supplémentaire (42) comprenant principalement au moins l'un des oxydes d'au moins l'un des éléments Si, Ti, Al, Mg, Ba, Ta, W, Bi, V, Ge, Ni, Th, Mo, Fe, La, Be, Sc et Co, au moins l'un des nitrures d'au moins l'un des éléments Ga, Si, Mg, Ta, Hf, Zr, Nb et B, et au moins l'un des halogénures d'au moins l'un des éléments Na, Mg, Li, Ba, Ca et K.

6. Dispositif de prise de vues comportant une pluralité d'éléments conformément à l'une quelconque des revendications précédentes.

7

# F I G. 1

# F I G. 2

FIG. 3

# FIG. 4

# FIG. 5

# FIG. 6

## F I G. 7

## F I G. 8

## FIG. 9

## FIG. 10